# EUROPEAN PATENT APPLICATION

(11) **EP 4 350 327 A1**
(43) Date of publication of application: **10.04.2024**
(21) Application number: 23191984.6
(22) Date of filing: 17.08.2023
(51) Int. Cl.: G01N 17/00, H01M 10/42

(54) **BATTERY CHARGING/DISCHARGING SYSTEM**

(30) Priority: 23.08.2022 KR 20220105175
(71) Applicant: WONIK PNE CO., LTD., Suwon-si, Gyeonggi-do 16648 (KR)
(72) Inventor: LEE, Seokmin, 16648 Suwon-si (KR); CHOI, Yonghwan, 16648 Suwon-si (KR); LEE, Hangyu, 16648 Suwon-si (KR); KIM, Youngseok, 16648 Suwon-si (KR); KIM, Hyoungjoong, 16648 Suwon-si (KR)
(74) Representative: Stöckeler, Ferdinand

(57) **Abstract**

The present disclosure provides a battery charging/discharging system capable of minimizing an amount of heat generated from a battery charger/discharger in a performance test process of a battery. The battery charging/discharging system according to the present disclosure includes a battery chamber in which a battery is mounted, a charger/discharger chamber forming a space isolated from the battery chamber and in which a charger/discharger configured to apply charging/discharging power to a battery is installed, an air conditioner configured to adjust a temperature in the battery chamber, and a charger/discharger cooling device installed inside the charger/discharger chamber and configured to cool the charger/discharger using air in a low-temperature state generated through heat exchange between refrigerant circulating therein and air circulating inside the charger/discharger chamber.

## Description

### [Technical Field]

The present disclosure relates to a battery charging/discharging system, and more specifically, to a battery charging/discharging system capable of minimizing an amount of heat generated from a battery charger/discharger in a performance test process of a battery.

### [Background Art]

Currently, types of secondary batteries widely used include a lithium ion battery, a lithium polymer battery, a nickel cadmium battery, a nickel hydride battery, a nickel zinc battery, etc.

Output characteristics of the secondary batteries may vary depending on surrounding environmental conditions. For example, the output characteristics of the secondary batteries may vary depending on a surrounding temperature state, an external impact, vibration, etc. Therefore, it is necessary to check in advance what kind of output characteristics the secondary battery provides under environmental conditions in which the secondary battery is actually used.

To this end, the secondary battery is tested to identify the output characteristics under various environmental conditions during a manufacturing process. In general, the secondary battery test is performed by a method of arranging a plurality of secondary battery cells in a chamber, creating a specific environment inside the chamber to charge and discharge the secondary battery cells in the corresponding environment, and measuring an operating state of the secondary battery cells.

Recently, due to the gradual increase in demand for secondary batteries, the demand for the secondary battery charging/discharging system for performing a charging/discharging test on the secondary battery is also increasing. Therefore, it is required to secure space for building facilities for a large-capacity secondary battery charging/discharging system, and in addition, the need for cost reduction in the construction and investment of new research buildings for building facilities for the secondary battery charging/discharging system is also gradually increasing.

In addition, various studies for reducing an air conditioning facility construction cost for reducing an amount of heat generated from the secondary battery charging/discharging system, a future maintenance cost, and the like, including research on the improvement in space utilization required to build a large-capacity secondary battery (hereinafter referred to as "battery") charging/discharging system facility are being conducted.

### [Summary of Invention]

### [Technical Problem]

The present disclosure is directed to providing a battery charging/discharging system, which may integrally form a battery chamber in which a battery to be tested is accommodated and a battery charger/discharger for applying charging/discharging power to the battery in one system structure, thereby minimizing an installation space of the battery charging/discharging system to implement cost saving.

The present disclosure is directed to providing a battery charging/discharging system, which may cool a charger/discharger by an air circulation cooling method according to the heat exchange between refrigerant and air inside a chamber in which the battery charger/discharger is installed, thereby minimizing an amount of heat generated from the battery charger/discharger to improve efficiency of the entire battery charging/discharging system.

### [Solution to Problem]

In order to achieve the objects, a battery charging/discharging system according to the present disclosure includes a battery chamber in which a battery is mounted, a charger/discharger chamber forming a space isolated from the battery chamber and in which a charger/discharger configured to apply charging/discharging power to a battery is installed, an air conditioner configured to adjust a temperature in the battery chamber, and a charger/discharger cooling device installed inside the charger/discharger chamber and configured to cool the charger/discharger using air in a low-temperature state generated through heat exchange between refrigerant circulating therein and air circulating inside the charger/discharger chamber.

Here, the charger/discharger chamber may be integrally configured in the form of one structure with the battery chamber.

In addition, the charger/discharger cooling device may include a compressor, a condenser, an expansion valve, and an evaporator through which the refrigerant circulates, and a blowing fan configured to blow the air in the low-temperature state generated through heat exchange with the refrigerant flowing inside the evaporator toward the charger/discharger, and the evaporator and the blowing fan may be installed at positions adjacent to the charger/discharger.

In this case, the blowing fan may be disposed between the charger/discharger and the evaporator.

In addition, the blowing fan may be integrally coupled with the evaporator.

In addition, a space part in which the air circulates and moves may be formed between upper surfaces of the evaporator and the blowing fan and a ceiling surface of the charger/discharger chamber.

In addition, a controller configured to control the charger/discharger and control the temperature in the battery chamber through the air conditioner, and a temperature sensor configured to detect and transmit a temperature of the charger/discharger to the controller may be installed in the battery charging/discharging system, and the controller may control a power on/off of the charger/discharger cooling device according to a temperature of the charger/discharger detected through the temperature sensor.

Meanwhile, the air conditioner may include a compressor, a condenser, an expansion valve, and an evaporator through which the refrigerant circulates, a blowing fan configured to blow the air in the low-temperature state generated through heat exchange with refrigerant flowing inside the evaporator into the battery chamber, and a heater disposed at an upstream side of the blowing fan to heat the air.

Here, the heater, the evaporator, and the blowing fan may be installed to be sequentially disposed in an air flow direction.

### [Advantageous Effects of Invention]

According to the configuration of the battery charging/discharging system of the present disclosure, by integrally forming the battery chamber in which the battery to be tested is accommodated and the battery charger/discharger for applying charging/discharging power to the battery within one battery charging/discharging system structure, it is possible to reduce the space area of the battery charging/discharging system, thereby increasing space utilization and greatly reducing the construction cost, the air conditioning cost, the maintenance cost, and the like for constructing the battery charging/discharging system facility.

In addition, by cooling the charger/discharger by the air circulation cooling method of exchanging heat between refrigerant and air through the charger/discharger cooling device installed inside the charger/discharger chamber, it is possible to minimize the amount of heat generated from the charger/discharger, thereby greatly increasing the efficiency of the entire battery charging/discharging system.

In particular, since the charger/discharger is cooled by generating air flow through the blowing fan provided on the charger/discharger cooling device and supplying the charger/discharger side with the generated air flow in the state of passing through the inside of the evaporator in which the low-temperature refrigerant circulates and then being cooled and the charger/discharger is continuously cooled through the circulation process in which the air cooling the charging/discharging device moves up by the convection phenomenon and then re-flows into the evaporator side, it is possible to greatly increase the cooling efficiency of the charging/discharging device.

In addition, by forming one module structure in which the blowing fan for generating air flow is integrally coupled to the evaporator, it is possible to reduce the installation space area inside the charger/discharger chamber, thereby increasing the space utilization inside the battery charging/discharging system.

### [Brief Description of Drawings]

FIG. 1 is a schematic diagram of a battery charging/discharging system according to an embodiment of the present disclosure.
FIG. 2 is a side view illustrating a state in which a charger/discharger cooling device is installed inside a charger/discharger chamber of the battery charging/discharging system.
FIG. 3 is an exemplary view illustrating a state in which air circulates inside the charger/discharger chamber according to driving of the charger/discharger cooling device.
FIG. 4 is a conceptual diagram illustrating a process of adjusting temperature/humidity of a battery chamber by an air conditioner and cooling of the charger/discharger by the charger/discharger cooling device inside the battery charging/discharging system.
FIGS. 5 and 6 are front and side views illustrating a configuration of a battery charging/discharging system according to another embodiment of the present disclosure.
FIGS. 7 and 8 are front and side views illustrating a configuration of a battery charging/discharging system according to still another embodiment of the present disclosure.

### [Description of Embodiments]

Hereinafter, embodiments of the present disclosure will be described in detail with reference to the accompanying drawings so that those skilled in the art can easily carry out the present disclosure.

However, the present disclosure may be implemented in various different forms and is not limited to the embodiments described herein. In addition, it should be noted that parts denoted by the same reference numerals throughout the detailed description indicate the same components.

Hereinafter, preferred embodiments of a battery charging/discharging system according to the present disclosure will be described in detail with reference to the accompanying drawings.

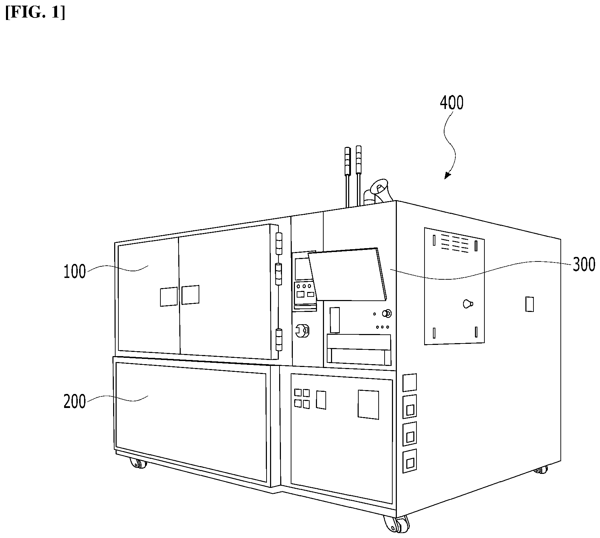

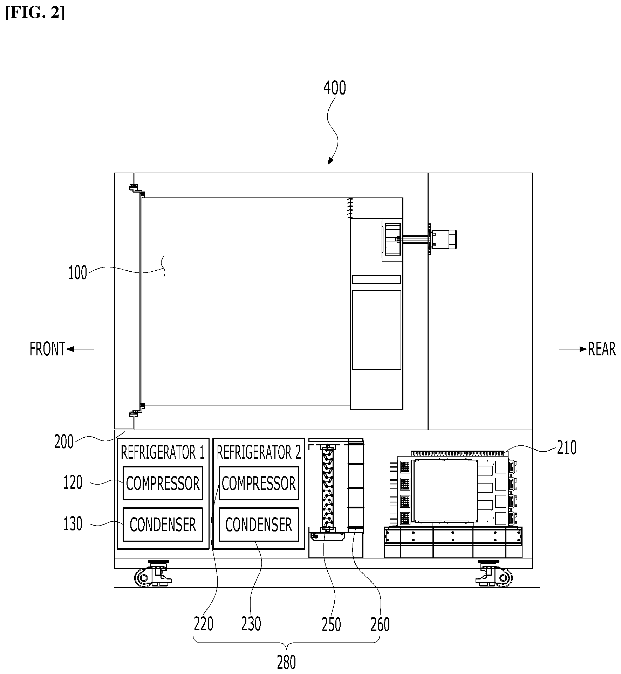

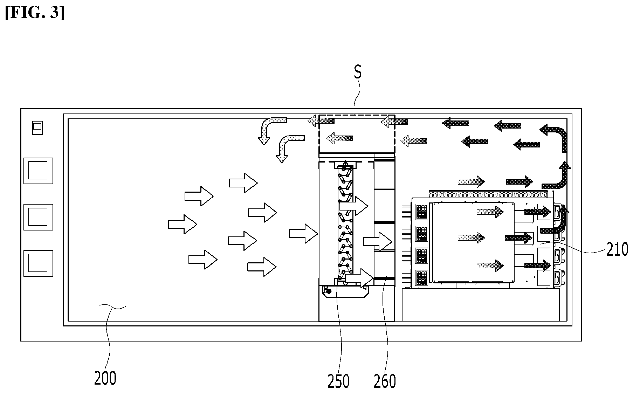

FIG. 1 is a schematic diagram of a battery charging/discharging system according to an embodiment of the present disclosure, and FIG. 2 is a side view illustrating a state in which a charger/discharger cooling device is installed inside a charger/discharger chamber of the battery charging/discharging system. In addition, FIG. 3 is an exemplary view illustrating a state in which air circulates inside the charger/discharger chamber according to driving of the charger/discharger cooling device.

Referring to FIGS. 1 to 3, a battery charging/discharging system 400 according to an embodiment of the present disclosure is a system for testing a battery (or a battery cell) and may charge or discharge a battery to be tested according to a predetermined schedule. In addition, the battery charging/discharging system 400 may measure and record states such as a current, a voltage, and a state of charge of a battery to be tested in a charging or discharging process. For example, the battery charging/discharging system 400 may be a formation device or a cycler used in a secondary battery post-process, but is not limited thereto.

The battery charging/discharging system 400 includes a battery chamber 100 in which a plurality of batteries (battery cells) to be tested are mounted, a charger/discharger chamber 200 in which a charger/discharger 210 for forming a space isolated from the battery chamber 100 and applying charging/discharging power to the battery is installed, an air conditioner 180 for adjusting temperature and humidity in the battery chamber 100, a controller 300 for controlling the temperature and humidity in the battery chamber 100 through the air conditioner 180 while controlling the charger/discharger 210, and a charger/discharger cooling device 280 for generating air flow inside the charger/discharger chamber 200 to cool the charger/discharger 210 through air in a low-temperature state generated through the heat exchange with refrigerant.

Here, the battery charging/discharging system 400 according to the present disclosure is configured in a form in which the battery chamber 100 in which the battery to be tested is mounted, the battery charger/discharger 210 for applying the charging/discharging power to the battery, and the controller 300 are integrated in one battery charging/discharging system 400 structure.

Conventionally, a system is generally formed in a structure in which a chamber equipped with a charger/discharger is separately provided outside a battery chamber to connect a battery inside the battery chamber with electrical wirings drawn out to the outside of a connector of the charger/discharger inside the charger/discharger chamber through a separate duct.

However, in the present disclosure, by integrally forming the charger/discharger chamber 200 in which the charger/discharger 210 is installed inside the one battery charging/discharging system 400 structure at a position adjacent to the battery chamber 100, it is possible to reduce a space area of the entire battery charging/discharging system 400. Therefore, it is possible to increase space utilization in a test room in which the battery charging/discharging system 400 is installed and greatly reduce a construction cost for constructing the battery charging/discharging system 400, and an air conditioning cost in the test room, a maintenance cost, and the like accordingly.

More specifically describing a configuration of the battery charging/discharging system 400 according to the present disclosure, each of two battery chambers 100 in which the plurality of batteries (battery cells) to be tested are mounted may be disposed at one of upper left and right sides of the battery charging/discharging system 400.

The charger/discharger chamber 200 in which the charger/discharger 210 is installed may be installed at a lower side adjacent to the battery chamber 100 as in the embodiment illustrated in FIG. 2.

In this case, the charger/discharger chamber 200 may form an isolated space not connected to the battery chamber 100, and thus, there is no inflow and outflow of air between the charger/discharger chamber 200 and the battery chamber 100. This is because temperature control of the battery chamber 100 in which the batteries to be tested are disposed needs to be precisely controlled and thus the introduction of outside air into the battery chamber 100 needs to be minimized.

In addition, the charger/discharger 210 installed inside the charger/discharger chamber 200 may be connected to each battery installed inside the battery chamber 100 through connection wires (not illustrated) to apply charging/discharging power to each battery according to a command of the controller 300.

Meanwhile, when the battery charging/discharging system 400 is operated, a lot of heat is generated in the charger/discharger 210 in the process of applying the charging/discharging power to the battery through the charger/discharger 210. For example, the charger/discharger 210 of 5 V 300 A 32 CH generates a lot of heat corresponding to an output power of 48 kW. As described above, the heat generated from the charger/discharger 210 in the charging/discharging process of the battery may reduce the efficiency of the system and in severe cases, there may be risk of fire such as battery explosion.

Therefore, the battery charging/discharging system 400 according to the present disclosure is provided with the charger/discharger cooling device 280 capable of continuously cooling the heat generated in the operation process of the charger/discharger 210 by an inside air circulation cooling method.

The charger/discharger cooling device 280 may be mounted inside the charger/discharger chamber 200 in which the charger/discharger 210 is installed to effectively cool the charger/discharger 210 using the refrigerant circulating inside the charger/discharger cooling device 280 and the cooling air generated through the heat exchange operation with the air circulating inside the charger/discharger chamber 200.

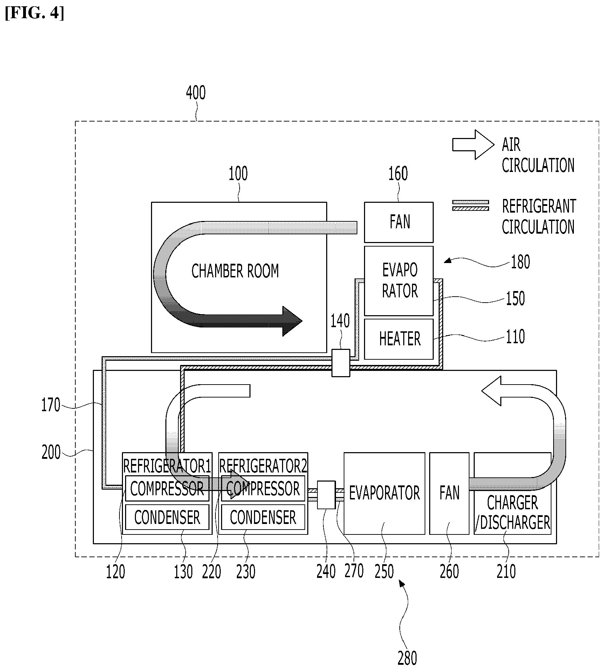

Specifically, as illustrated in FIG. 4, the charger/discharger cooling device 280 may include a compressor 220, a condenser 230, an expansion valve 240, and an evaporator 250 in which refrigerant circulates.

Here, the compressor 220 serves to compress the gaseous refrigerant and convert the compressed refrigerant into a high-temperature and high-pressure gas.

As the compressor 220, an electronic compressor capable of proportional integral differential (PID) control of a revolution per minute (RPM) of the compressor through the controller 300 may be provided.

In addition, the condenser 230 serves to condense the high-temperature and high-pressure gas discharged from the compressor 220 and convert the condensed gas into a high-temperature and high-pressure liquid.

In addition, the expansion valve 240 expands the high-temperature and high-pressure liquid discharged from the condenser 230 and converts the liquid into a low-temperature and low-pressure liquid state.

As the expansion valve 240, an electronic expansion valve (EEV) capable of adjusting an amount of opening by the PID control through the controller 300 may be applied. However, in order to reduce an installation cost and the like, the expansion valve 240 may also be applied in the form of a mechanical expansion valve of which an opening amount may not be adjusted, as necessary.

The evaporator 250 may convert the low-temperature and low-pressure liquid introduced from the expansion valve 240 into a low-temperature and low-pressure gaseous state through heat exchange with outside air.

Meanwhile, a blowing fan 260 capable of blowing low-temperature air generated through heat exchange with the refrigerant flowing into the evaporator 250 toward the charger/discharger 210 is installed in the charger/discharger cooling device 280.

The blowing fan 260 may generate air flow inside the charger/discharger chamber 200 and supply the charger/discharger 210 side with the air flow passing through the evaporator 250 in a state of exchanging heat with the refrigerant in the low-temperature and low-pressure state flowing into the evaporator 250 and being cooled, thereby cooling the charger/discharger 210 through the air flow in the low-temperature state.

At this time, the compressor 220 and the condenser 230 constituting the charger/discharger cooling device 280 may be installed at positions relatively far from the charger/discharger 210 inside the charger/discharger chamber 200, and the evaporator 250 and the blowing fan 260 may be installed at positions adjacent to the charger/discharger 210.

That is, the evaporator 250 and the blowing fan 260 for directly cooling the charger/discharger 210 may be installed at positions adjacent to the charger/discharger 210, and the compressor 220 and the condenser 230 generating heat in the process of compressing and condensing the refrigerant may be installed at positions relatively far from the charger/discharger 210.

In addition, the heat generated in the operation process of the condenser 230 may be cooled by cooling water introduced from the outside along a separate cooling water line (not illustrated).

For example, a separate cooling system (not illustrated) may be provided in a building in which the battery charging/discharging system 400 is installed and may cool the heat generated from the condenser 230 through the cooling water drawn out from the cooling system and introduced along the separate cooling water line drawn connected to an inner side of the battery charging/discharging system 400.

As described above, when the heat generated from the condenser 230 is cooled by a water-cooled structure using cooling water (water) rather than an air-cooled structure using wind (air), it is possible to minimize an amount of the external heat generated from the condenser 230, thereby greatly reducing the amount of external heat of the entire battery charging/discharging system 400.

In addition, the blowing fan 260 for generating air flow in the charger/discharger chamber 200 may be disposed between the charger/discharger 210 and the evaporator 250 and coupled integrally with the evaporator 250.

As described above, when the blowing fan 260 is coupled to the evaporator 250 and installed in the form of a single unit, it is possible to save a space of each component in a limited space inside the charger/discharger chamber 200, thereby increasing space utilization and facilitating the installation and lot management of the corresponding component.

Meanwhile, in the operation process of the charger/discharger cooling device 280, the charger/discharger 210 may be continuously cooled through the internal circulation process in which the low-temperature air blown toward the charger/discharger 210 through the blowing fan 260 after passing the evaporator 250 cools the charger/discharger 210 and then is heated, and the air with increase temperature moves up, then moves to a front side of the evaporator 250 to flow into the evaporator 250, and then continuously cool the charger/discharger 210.

To this end, a space part S having a constant area is formed between upper surfaces of the evaporator 250 and the blowing fan 260 and a ceiling surface of the charger/discharger chamber 200 so that the circulation movement of the air may be performed.

Therefore, it is possible to implement the air circulation cooling method in which the low-temperature air blown to the charger/discharger 210 through the evaporator 250 and the blowing fan 260 cools the charger/discharger 210 and then becomes a state of being heated to move to a front side space of the evaporator 250 through the space part S, and the air moving to the front side space of the evaporator 250 becomes a low-temperature state through the evaporator 250 and the blowing fan 260 again and then is supplied to the charger/discharger 210 to repeatedly cool the charger/discharger 210.

As described above, when the charger/discharger 210 is cooled by the air circulation cooling method inside the charger/discharger chamber 200, the inside of the charger/discharger chamber 200 may be maintained in an almost sealed state without inflow and outflow of air from and to the outside.

This can be made possible by cooling the heat generated from the condenser 230 through a separately provided water-cooling cooling system. Therefore, according to the present disclosure, it is possible to continuously and effectively cool the charger/discharger 210 by the air circulation cooling method by using the charger/discharger cooling device 280 even in a situation in which the inside of the charger/discharger chamber 200 is sealed.

In particular, since the air heated after cooling the charger/discharger 210 inside the charger/discharger chamber 200 is not discharged to the outside and repeatedly cools the charger/discharger 210 while continuously circulating inside the charger/discharger chamber 200 in the sealed state, the amount of heat generated from the charger/discharger 210 may actually converge to a value close to about "0".

As described above, in the battery charging/discharging system 400 according to the present disclosure, since almost no heat is generated from the charger/discharger 210, including the condenser 230, and thus almost no heat emitted from the battery charging/discharging system 400 is generated, it is not necessary to construct a separate external air conditioning facility inside the test room to cancel the external heat of the battery charging/discharging system 400. Therefore, it is possible to reduce the construction cost required to construct the external air conditioning facility.

Meanwhile, in the battery charging/discharging system 400, the starting of the charger/discharger cooling device 280 may be automatically performed by a control signal transmitted from the controller 300 according to temperature conditions inside the charger/discharger chamber 200.

To this end, a temperature sensor (not illustrated) for detecting a temperature of the charger/discharger 210 and transmitting the detected temperature to the controller 300 may be installed inside the charger/discharger chamber 200.

The temperature sensor may be installed directly on the charger/discharger 210 portion or installed at a position adjacent to the charger/discharger 210 to detect the temperature of the charger/discharger 210 or the internal temperature of the charger/discharger chamber 200.

In addition, the controller 300 may control the power on/off of the charger/discharger cooling device 280 according to the temperature of the charger/discharger 210 or internal temperature of the charger/discharger chamber 200 detected through the temperature sensor.

For example, the controller 300 may start the charger/discharger cooling device 280 to perform air circulation cooling on the charger/discharger 210 when the temperature of the charger/discharger 210 or the internal temperature of the charger/discharger chamber 200 detected through the temperature sensor exceeds a set reference temperature and control the starting of the charger/discharger cooling device 280 to stop when the temperature of the charger/discharger 210 or the internal temperature of the charger/discharger chamber 200 is smaller than the reference temperature.

Meanwhile, FIG. 4 schematically illustrates a state in which the temperature/humidity adjustment inside the battery chamber by the air conditioner and the charger/discharger cooling by the charger/discharger cooling device are simultaneously performed in the battery charging/discharging system 400 according to the present disclosure.

As illustrated in FIG. 4, temperature and humidity inside the battery chamber 100 in which the plurality of batteries are mounted may be adjusted through the air conditioner 180 installed inside the battery charging/discharging system 400.

The air conditioner 180 may include the compressor 120, the condenser 130, the expansion valve 140, and the evaporator 150 through which refrigerant circulates, and the compressor 120, the condenser 130, the expansion valve 140, and the evaporator 150 may be sequentially connected along a refrigerant line 170 to perform the refrigerant circulation.

In this case, the compressor 120 and the condenser 130 constituting the air conditioner 180 may be installed in an internal space of the charger/discharger chamber 200 together with the compressor 220 and the condenser 230 constituting the charger/discharger cooling device 280.

In addition, the blowing fan 160 for blowing the low-temperature air generated through the heat exchange with the refrigerant flowing into the evaporator 150 into the battery chamber 100, and a heater 110 disposed at an upstream side of the air flow of the blowing fan 160 to heat the air may be installed in the air conditioner 180.

Here, the heater 110 may be provided in the form of an electric heater capable of adjusting the amount of heat generated through the controller 300 and may adjust an amount of heat of the electric heater according to a necessary situation to adjust the temperature of the air blown into the battery chamber 100.

In this case, the heater 110, the evaporator 150, and the blowing fan 160 may be installed in a structure sequentially disposed in an air flow direction. Therefore, the refrigerant flowing into the expansion valve 140 along the refrigerant line 170 through the compressor 120 and the condenser 130 may expand to the expansion valve 140 and then flow into the evaporator 150 in a state of being reduced in temperature and pressure, and the air flowing by the operation of the blowing fan 160 may exchange heat with the low-temperature refrigerant while passing through the evaporator 150 and then flow into the battery chamber 100 through the blowing fan 160, thereby maintaining the temperature inside the battery chamber 100 as the low-temperature state.

In addition, the inside of the battery chamber 100 may be continuously cooled through the internal air circulation process in which the air heated after cooling the inside of the battery chamber 100 flows into the battery chamber 100 in a state of being discharged to the outside of the battery chamber 100 and then re-flows into the evaporator 150 side and cooled.

In addition, the heat generated from the condenser 130 disposed inside the charger/discharger chamber 200 may be cooled by the cooling water introduced from the outside along the cooling water line (not illustrated), thereby minimizing an amount of the external heat generated by the condenser 130.

Meanwhile, in order to increase the internal temperature of the battery chamber 100, the starting of the compressor 120 is stopped to prevent the circulation of the refrigerant, and in this situation, only the heater 110 and the blowing fan 160 may be operated so that the air heated by the heater 110 flows into the battery chamber 100 through the blowing fan 160, thereby increasing the temperature inside the battery chamber 100.

In addition, when it is necessary to adjust the temperature and humidity inside the battery chamber 100, an output of the compressor 120 or the heater 110 is adjusted through the controller 300, or the compressor 120 and the heater 110 are simultaneously driven so that the air heated through the heater 110 exchanges heat with refrigerant in the evaporator 150 and then flows into the battery chamber 100, and thus the temperature and humidity of the air flowing into the battery chamber 100 may be adjusted.

That is, when current temperature and humidity inside the battery chamber 100 is respectively detected through a temperature sensor (not illustrated) and a humidity sensor (not illustrated) and then it is necessary to adjust temperature and humidity according to the detected result values, the controller 300 may control each of the temperature and humidity inside the battery chamber 100 to a necessary level by controlling each of the RPM of the compressor 120, the amount of heat of the heater 110, and the output of the blowing fan 160.

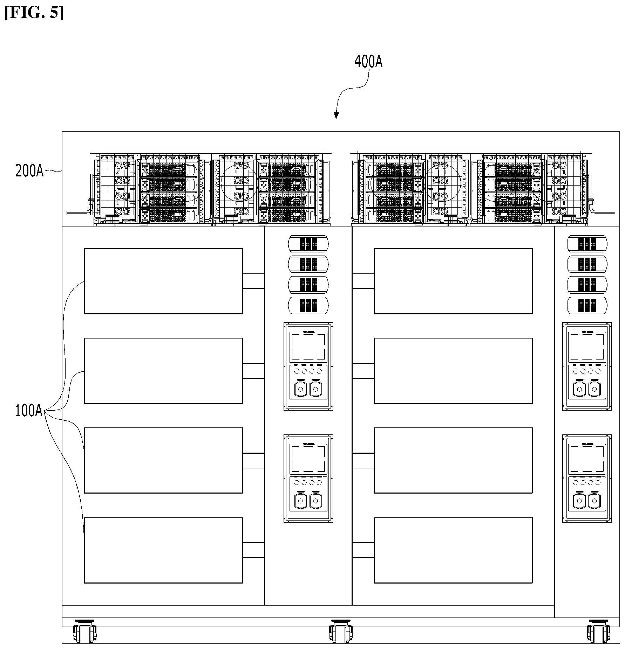

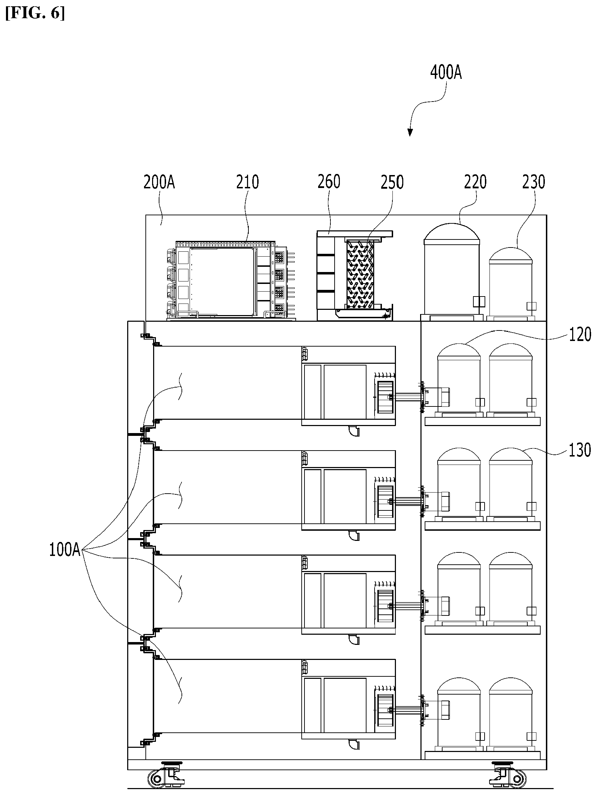

Meanwhile, FIGS. 5 and 6 are front and side views illustrating a battery charging/discharging system 400A according to another embodiment of the present disclosure.

The battery charging/discharging system 400A illustrated in FIGS. 5 and 6 has a form composed of eight battery chambers 100A, and FIGS. 5 and 6 illustrate the form in which a charger/discharger chamber 200A in which the charger/discharger 210 and the charger/discharger cooling device 280 are installed is disposed at an uppermost portion of the battery chamber 100A are disposed.

In this case, the air conditioner 180 including the heater 110 capable of adjusting temperature and humidity in each battery chamber 100A, the compressor 120, the condenser 130, the expansion valve 140, the evaporator 150, and the blowing fan 160 may be individually installed in a rear side space of each battery chamber 100A.

In addition, the charger/discharger cooling device 280 capable of cooling the charger/discharger 210 for applying the charging/discharging power to a battery mounted inside each battery chamber 100A may be installed inside the charger/discharger chamber 200A disposed on the uppermost portion of the battery charging/discharging system 400A.

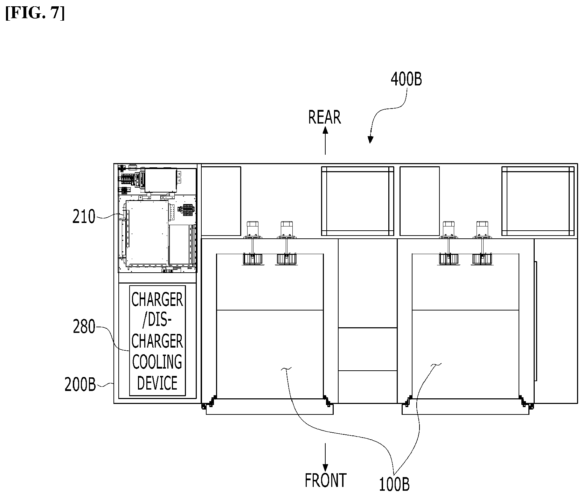

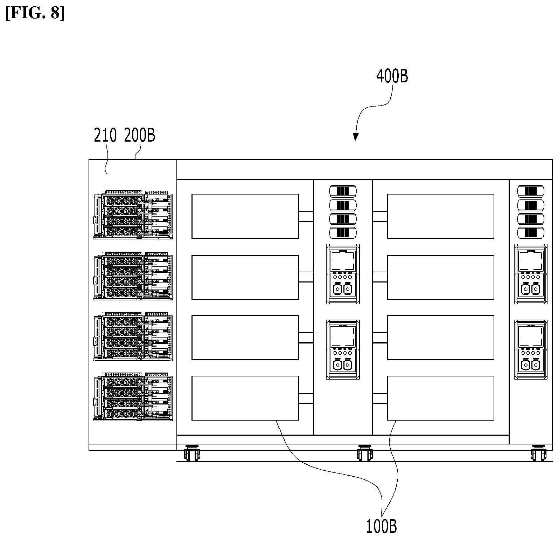

FIGS. 7 and 8 illustrate a structure of a battery charging/discharging system 400B according to still another embodiment of the present disclosure, and the battery charging/discharging system 400B illustrated in FIGS. 7 and 8 has a form that includes eight battery chambers 100B and a charger/discharger chamber 200B including the charger/discharger 210 and the charger/discharger cooling device 280 is individually installed on one side surface adjacent to each battery chamber 100B.

That is, the charger/discharger chamber 200B including the charger/discharger 210 for applying the charging/discharging power to the battery mounted on the battery chamber 100B of each layer and the charger/discharger cooling device 280 capable of cooling the charger/discharger 210 may be individually installed for each layer on one side surface portion inside the battery charging/discharging system 400B.

In this case, each charger/discharger 210 installed inside a plurality of charger/discharger chambers 200B may be configured to be cooled through one charger/discharger cooling device 280, or the charger/discharger 210 may also be cooled by installing the charger/discharger cooling device 280 for each charger/discharger chamber 200B in which the charger/discharger 210 is installed.

As described above, the battery charging/discharging system according to the present disclosure may be configured in various forms by varying installation positions of the charger/discharger chambers and the number of installed charger/discharger chambers according to the number and arrangement form of battery chambers installed in the battery charging/discharging system, and in addition, the charger/discharger cooling device 280 may also be configured in various forms by varying the number of installed charger/discharger chambers and the installation positions thereof.

As described above, in the present disclosure, by integrally forming the battery chamber 100 and the charger/discharger chamber 200 conventionally installed separately in the form of a separate structure in the battery charging/discharging system 400 structure, it is possible to reduce the space area of the entire battery charging/discharging system 400, thereby increasing the space utilization according to the construction of the battery charging/discharging system 400 and greatly saving the overall required costs such as a construction cost, an air conditioning construction cost, and a future maintenance cost according to the construction of the battery charging/discharging system 400 facility.

In addition, since the battery charging/discharging system 400 according to the present disclosure continuously cools the charger/discharger 210 by the air circulation cooling method by the operation of the charger/discharger cooling device 280 inside the charger/discharger chamber 200, it is possible to minimize the amount of heat generated from the charger/discharger 210 and also effectively cool the heat generated during operations of the air conditioner 180 and the charger/discharger cooling device 280 by the water-cooling structure by the cooling water introduced from the outside, thereby greatly reducing the amount of external heat of the entire battery charging/discharging system 400. Therefore, since it is not necessary to construct the additional air conditioning facility for canceling the external heat of the battery charging/discharging system 400 in the test room, it is possible to save the overall costs according to the construction of the air conditioning facility.

Meanwhile, in the specification, the continuous cooling of the charger/discharger 210 by the air circulation cooling method by the operation of the charger/discharger cooling device 280 inside the charger/discharger chamber 200 has been mainly described, but according to the embodiments, the charger/discharger 210 may also have its own cooling system. For example, the cooling system of the charger/discharger 210 itself may be a water-cooling system.

For example, the charger/discharger 210 may include a plurality of switching elements for converting power. The cooling system of the charger/discharger 210 may include a heat pipe through which cooling water (or refrigerant) passes, and a heat sink including the heat pipe. In this case, the heat sink and the heat pipe of the cooling system may be disposed to surround the switching elements. For example, the heat sink and the heat pipe may be disposed on a board on which the switching elements are mounted. According to this structure, the cooling of the charger/discharger 210 may be performed by itself. Meanwhile, the cooling water supplied to the cooling system of the charger/discharger 210 may be supplied from the cooling device 280 or the air conditioner 180. For example, the cooling system of the charger/discharger 210, the air conditioner 180, and the cooling device 280 may share cooling water, but the present disclosure is not limited thereto.

Although the preferred embodiments of the present disclosure have been described above, the scope of the present disclosure is not limited to only these specific embodiments, and those skilled in the art can appropriately modify the present disclosure within the scope described in the claims of the present disclosure.

## Claims

1. A battery charging/discharging system comprising:
a battery chamber in which a battery is mounted;
a charger/discharger chamber forming a space isolated from the battery chamber and in which a charger/discharger configured to apply charging/discharging power to the battery is installed;
an air conditioner configured to adjust a temperature in the battery chamber; and
a charger/discharger cooling device installed inside the charger/discharger chamber and configured to cool the charger/discharger using air in a low-temperature state generated through heat exchange between refrigerant circulating therein and air circulating inside the charger/discharger chamber.

2. The battery charging/discharging system of claim 1, wherein the charger/discharger chamber is integrally configured in the form of one structure with the battery chamber.

3. The battery charging/discharging system of claim 1, wherein the charger/discharger cooling device includes a compressor, a condenser, an expansion valve, and an evaporator, and
a blowing fan configured to blow the air in the low-temperature state generated through heat exchange with the refrigerant flowing inside the evaporator toward the charger/discharger, and
the evaporator and the blowing fan are installed at positions adjacent to the charger/discharger.

4. The battery charging/discharging system of claim 3, wherein the blowing fan is disposed between the charger/discharger and the evaporator.

5. The battery charging/discharging system of claim 3, wherein the blowing fan is integrally coupled with the evaporator.

6. The battery charging/discharging system of claim 3, wherein a space part in which the air circulates is formed between upper surfaces of the evaporator and the blowing fan and a ceiling surface of the charger/discharger chamber.

7. The battery charging/discharging system of claim 1, further comprising:
a controller configured to control the charger/discharger and control the temperature in the battery chamber through the air conditioner; and
a temperature sensor configured to detect and transmit a temperature of the charger/discharger to the controller, and
wherein the controller controls a power on/off of the charger/discharger cooling device according to the temperature of the charger/discharger detected through the temperature sensor.

8. The battery charging/discharging system of claim 1, wherein the air conditioner includes:
a compressor, a condenser, an expansion valve, and an evaporator through which the refrigerant circulates;
a blowing fan configured to blow the air in the low-temperature state generated through heat exchange with refrigerant flowing inside the evaporator into the battery chamber; and
a heater disposed at an upstream side of the blowing fan to heat the air.

9. The battery charging/discharging system of claim 8, wherein the heater, the evaporator, and the blowing fan are sequentially disposed in an air flow direction.
